# EUROPÄISCHE PATENTSCHRIFT

(11) **EP 1 350 043 B1**
(45) Veröffentlichungstag und Bekanntmachung des Hinweises auf die Patenterteilung: **06.04.2005**
(21) Anmeldenummer: 02700146.0
(22) Anmeldetag: 09.01.2002
(51) Int. Cl.: F16H 61/00, H05K 7/20

(54) **ANORDNUNG EINER KUNSTSTOFF-SCHALTPLATTE EINES HYDRAULISCHEN KRAFTFAHRZEUG-GETRIEBESTEUERGERÄTES**
DEVICE OF A PLASTIC CONTROL PLATE IN A GEARBOX CONTROL DEVICE OF A HYDRAULIC MOTOR VEHICLE
DISPOSITIF DE PLAQUE DE CONNEXION EN MATIERE PLASTIQUE POUR COMMANDE DE BOITE DE VITESSES DE VEHICULE AUTOMOBILE

(30) Priorität: 11.01.2001 DE 10101091; 27.09.2001 DE 20115922 U
(43) Veröffentlichungstag der Anmeldung: 08.10.2003
(73) Patentinhaber: SIEMENS AKTIENGESELLSCHAFT, 80333 München (DE)
(72) Erfinder: ALBERT, Roland, 93047 Regensburg (DE); REKOFSKY, Andreas, 93087 Alteglofsheim (DE); SCHEUERER, Ulf, 93047 Regensburg (DE); FRITZSCHE, Christian, 93047 Regensburg (DE)
(86) Internationale Anmeldenummer: PCT/DE2002/000044
(87) Internationale Veröffentlichungsnummer: WO 2002/055908

(56) Entgegenhaltungen:
- EP-A- 0 841 842
- EP-A- 1 168 906
- DE-A- 19 710 931
- DE-A- 19 715 592

## Beschreibung

Die Erfindung betrifft eine Kunststoff-Schaltplatte eines hydraulischen Kraftfahrzeug-Getriebesteuergerätes.

Mittels eines hydraulischen Getriebesteuergerätes, welches die Druckverstärkung, die Volumenstromverstärkung und die Verteilung der Hydraulikflüssigkeit durchführt, wird die mechanische Steuerung des Getriebes bewerkstelligt. Um die Verteilung der Hydraulikflüssigkeit zu gewährleisten, weist das hydraulische Getriebesteuergerät eine oder mehrere Metallplatten (Schaltplatte, Kanalplatte) auf, in denen Kanäle für Hydraulikflüssigkeit ausgebildet sind.

Im Kraftfahrzeugbau wird mehr und mehr versucht, eine kompaktere Bauweise verschiedenster Komponenten eines Kraftfahrzeugs zu erreichen. So werden in Kraftfahrzeug-Getrieben vermehrt integrierte elektronisch-hydraulische Getriebesteuerungen eingesetzt. Beispielsweise wird bei einem mit dem Begriff "Vorortelektronik" umrissenen Konzept eine Steuerelektronik für das hydraulische Steuergerät innerhalb des Getriebes angeordnet und dadurch eine integrierte Getriebesteuerung hergestellt. Dabei dienen die Metallplatten des Getriebesteuergerätes dazu, elektrische Bauelemente wie beispielsweise Sensoren oder Aktuaktoren, beispielsweise Magnetventile, oder auch die Steuerelektronik darauf zu befestigen. Eine ausreichende Wärmeabfuhr der in diesen Bauteilen produzierten Wärme muss gewährleistet sein.

Aus der Druckschrift EP 0 841 842 A1 ist ein Steuergerät zur Ansteuerung des Elektromotors von Kraftfahrzeugen bekannt, bei dem ein von einem Kühlmedium durchströmtes, eine metallische Oberfläche aufweisendes Kühlmodul vorgesehen ist. Halbleiterbauelemente eines Funktionsmoduls sind dabei auf einem Schaltungsträger angeordnet und über einen separaten metallischen Trägerkörper mit einer Oberflächenseite des Kühlmoduls verbunden.

Der Erfindung liegt die Aufgabe zugrunde, eine aus der EP-A-841842 bekannte Anordnung bestehend aus einer Schaltplatte und einer Steuerelektronik weiterzubilden, so daß sie kostengünstig herstellbar ist und eine auch für die wärmeerzeugenden Bauteile ausreichende Wärmeabfuhr ermöglicht. Insbesondere soll eine kompakte Ausführung erreichbar sein.

Diese Aufgabenstellung wird durch die Merkmale des Patentanspruchs 1 gelöst.

Ausgangspunkt der Erfindung ist eine aus Kunststoff gefertigte Schaltplatte, welche in einem hydraulischen Kraftfahrzeug-Getriebesteuergerät angeordnet ist. In der Kunststoff-Schaltplatte erstreckt sich zumindest ein Kanal zur Leitung eines Kühlmediums, insbesondere einer Hydraulikflüssigkeit. Die der Erfindung zugrunde liegende Idee besteht darin, die Kunststoff-Schaltplatte so auszubilden, dass eine ausreichende Wärmeabfuhr gewährleistet ist. Zusätzlich zu dem Kanal ist ein Wärmeleitungskörper in die Kunststoff-Schaltplatte zumindest teilweise integriert, wodurch eine Wärmesenke in der Kunststoff-Schaltplatte ausgebildet ist. Da der Wärmeleitungskörper unmittelbar angrenzend an den Kanal angeordnet ist, ist eine effektive Wärmeabfuhr gewährleistet. Durch die Integration des Wärmeleitungskörpers in die Kunststoff-Schaltplatte weist diese darüber hinaus eine kompakte Bauweise auf.

Vorteilhafterweise ist der Wärmeleitungskörper als Metallplatte, insbesondere als Aluminiumplatte, ausgebildet.

Eine weitere vorteilhafte Ausgestaltung der Erfindung besteht darin, den Wärmeleitungskörper und den Kanal derart zueinander anzuordnen, dass der Wärmeleitungskörper von dem im Kanal fließenden Kühlmedium angeströmt wird. Konstruktiv kann dies so realisiert sein, dass ein Flächenbereich des Wärmeleitungskörpers als zumindest ein Wandbereich des Kanals ausgebildet ist.
Indem der Wärmeleitungskörper derart in die Kunststoff-Schaltplatte integriert ist, dass die Oberfläche der Schaltplatte bündig mit der Oberfläche des Wärmeleitungskörpers ist, kann die Schaltplatte ebenflächig ohne zusätzlichen Platzbedarf für den Wärmeleitungskörper hergestellt werden. Insbesondere kann der Wärmeleitungskörper auch in Form eines auf dem Kopf stehenden U's ausgebildet sein.

Vorteilhafterweise ist eine im Betrieb wärmeerzeugende Getriebesteuerelektronik, insbesondere ein die Elektronikbauelemente derselben tragendes Substrat unmittelbar auf der Oberfläche des Wärmeleitungskörpers angeordnet. Dadurch kann eine ausreichende Verlustleistungsabfuhr der Elektronikbauelemente gewährleistet werden und eine Beschädigung oder Zerstörung der Getriebesteuerelektronik aufgrund eines Überhitzens sicher ausgeschlossen werden.

Weitere vorteilhafte Ausgestaltungen der Erfindung sind in den Unteransprüchen angegeben.

Die Erfindung wird nachfolgend anhand von Ausführungsbeispielen unter Bezugnahme auf die Zeichnungen beschrieben. Es zeigen:
- Fig. 1: einen Querschnitt durch ein erstes Ausführungsbeispiel der erfindungsgemäßen Kunststoff-Schaltplatte;
- Fig. 2: eine schematische Darstellung einer Draufsicht auf die Anordnung gemäß Fig. 1;
- Fig. 3: einen Querschnitt durch ein zweites Ausführungsbeispiel der Kunststoff-Schaltplatte;
- Fig. 4: eine schematische Darstellung der Draufsicht auf die Anordnung gemäß Fig. 3; und
- Fig. 5: einen Querschnitt durch ein drittes Ausführungsbeispiel der Kunststoff-Schaltplatte.

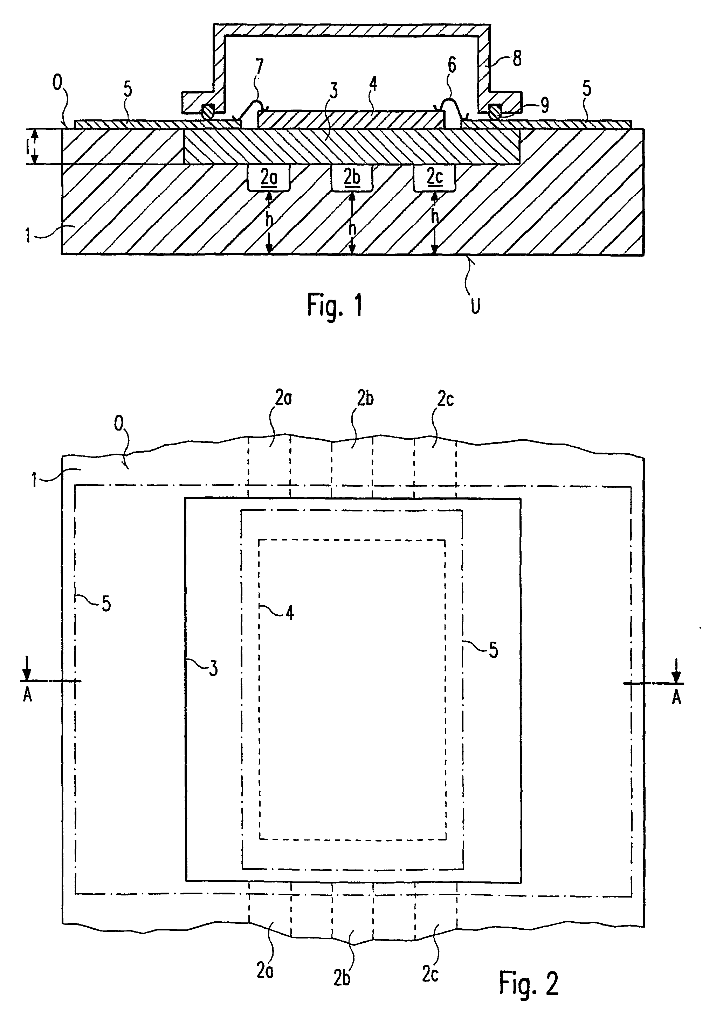

Eine Kunststoff-Schaltplatte 1 (Fig. 1) ist als ein spritzgegossener Kunststoffkörper ausgebildet und bildet einen Teil eines Hydrauliksteuergehäuses eines hydraulischen Kraftfahrzeug-Getriebesteuergerätes. Das hydraulische Kraftfahrzeug-Getriebesteuergerät ist beispielsweise im unteren Bereich des Getriebegehäuses befestigt, so dass es innerhalb der Ölwanne liegt.

Die Kunststoff-Schaltplatte 1 weist drei Kanäle 2a, 2b und 2c auf. Die Kanäle 2a, 2b und 2c weisen im Ausführungsbeispiel alle den gleichen Querschnitt auf und sind mit einem Abstand h beabstandet zur Unterseite U der Kunststoff-Schaltplatte 1 in dieser ausgebildet. Jeweils drei Seiten der im Querschnitt rechteckig ausgebildeten Kanäle 2a, 2b und 2c werden unmittelbar durch die Kunststoff-Schaltplatte 1 begrenzt. Ein Wärmeleitungskörper 3, der im Ausführungsbeispiel als einstückige Metallplatte, insbesondere als Aluminiumplatte ausgebildet ist, ist in der Kunststoff-Schaltplatte 1 integriert.

Der Wärmeleitungskörper 3 weist eine konstante Dicke 1 auf und ist über den Kanälen 2a, 2b und 2c angeordnet. Flächenbereiche des Wärmeleitungskörper 3 an dessen Unterseite bilden dabei jeweils einen der vier Wandbereiche bei jedem der rechteckförmigen Kanäle 2a, 2b und 2c. Dadurch wird der Wärmeleitungskörper 3 direkt von dem durch die Kanäle 2a, 2b und 2c fließenden Kühlmedium angeströmt. Der Wärmeleitungskörper 3 ist in die Kunststoff-Schaltplatte 1 integriert und seine Oberfläche ist bündig mit der Oberfläche O der Kunststoff-Schaltplatte 1.

Auf den in die Kunststoff-Schaltplatte 1 integrierten Wärmeleitungskörper 3 ist eine Getriebesteuerelektronik in Form einer die Elektronikbauelemente (nicht dargestellt) tragenden Leiterplatte 4 angeordnet. Die Leiterplatte 4 ist vorzugsweise mit ihrer gesamten Unterseitenfläche unmittelbar auf dem Wärmeleitungskörper 3 angeordnet und z.B. mittels eines Wärmeleitklebers mit dieser verklebt.

Eine weitere Leiterplatte 5, beispielsweise in Form einer flexiblen Leiterplatte, ist teilweise auf der Oberfläche O der Kunststoff-Schaltplatte 1 und teilweise auf dem Wärmeleitungskörper 3 angeordnet. Die Leiterplatte 5 kontaktiert die die Elektronikbauelemente tragende Leiterplatte 4 über Bonddrähte 6 und 7. Es kann auch vorgesehen sein, die Leiterplatte 5 als Stanzgitter auszuführen, das auf der Kunststoff-Schaltplatte 1 eingespritzt oder vergossen wird.

Um die auf der Leiterplatte 4 angeordneten Elektronikbauelemente der Getriebesteuerschaltung vor dem Umgebungsmedium (Öl) zu schützen, ist eine Abdeckung 8 über der Leiterplatte 4 angeordnet. Die Abdeckung 8 liegt über einem Dichtring 9 auf der Leiterplatte 5 auf und realisiert einen öldichten Gehäuseraum für die Getriebesteuerelektronik.

Die Anbringung der aus Metall oder Kunststoff bestehenden Abdeckung 8 kann über nicht dargestellte Nieten, Schrauben, Presstiftverbindungen oder dergleichen erfolgen.

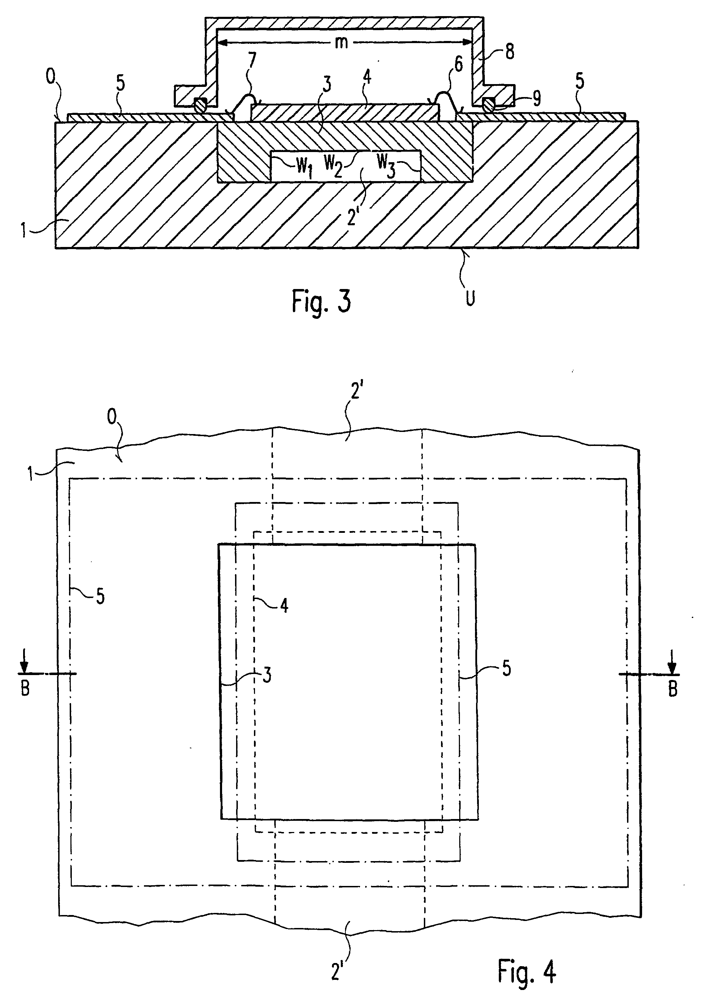

In Fig. 2 ist eine schematische Darstellung einer Draufsicht auf die in Fig. 1 beschriebene Anordnung dargestellt. Die Darstellung gemäß Fig. 1 zeigt einen Querschnitt bezüglich der Schnittlinie AA. Entsprechend der Fig. 2 ist die Leiterplatte 4 mit ihrer Fläche vollständig auf dem Wärmeleitungskörper 3 angeordnet. Die durch Umrisslinien dargestellte Leiterplatte 5 ist beabstandet zur Leiterplatte 4 auf dem Wärmeleitungskörper 3 und der Oberfläche O der Kunststoff-Schaltplatte 1 angeordnet und umgibt die Leiterplatte 4 auf der Oberfläche des Wärmeleitungskörpers 3 vollständig. Die durch ihre Begrenzungslinien dargestellten Kanäle 2a, 2b und 2c verlaufen im Ausführungsbeispiel parallel zueinander. Der Verlauf der Kanäle 2a, 2b und 2c in der Kunststoff-Schaltplatte 1 kann aber auch in vielfältiger Weise ausgebildet sein.

In einem zweiten Ausführungsbeispiel gemäß Fig. 3 werden gleiche oder funktionsgleiche Bauelemente mit den gleichen Bezugszeichen versehen. Der Wärmeleitungskörper 3 ist als einstückige, U-förmige Aluminiumplatte ausgebildet. Das in dem Kanal 2' fließende Kühlmedium strömt den Wärmeleitungskörper 3 an drei Wandbereichen W₁, W₂ und W₃ des Kanals 2' an. Durch eine derartige geometrische Gestaltung des Wärmeleitungskörpers 3 und des Kanals 2' wird die durch die im Betrieb der auf der Leiterplatte 4 angeordneten Steuerelektronik erzeugte Wärme besonders effektiv abgeführt. Der Wärmeleitungskörper 3 weist eine Breite auf, die einer Innenwandweite m der Abdeckung 8 entspricht und ist daher kleiner ausgebildet als der Wärmeleitungskörper 3 in den Figuren 1 und 2.

In Fig. 4 ist eine schematische Darstellung der Draufsicht der Anordnung gemäß Fig. 3 aufgezeigt. Fig. 3 stellt einen Querschnitt entlang der Schnittlinie BB dar. Der durch seine Umrisslinien dargestellte Wärmeleitungskörper 3 ist derart ausgeführt, dass die Unterseitenfläche der Leiterplatte 4 nur teilweise auf der mit der Oberfläche O der Kunststoff-Schaltplatte 1 bündigen Oberfläche des Wärmeleitungskörpers 3 angeordnet ist.

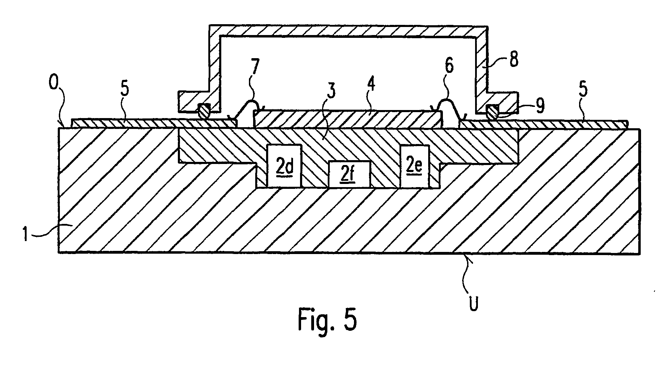

Im Ausführungsbeispiel gemäß Fig. 5 ist eine weitere mögliche geometrische Gestaltung des Wärmeleitungskörpers 3 sowie von Kanälen 2d, 2e und 2f dargestellt. Der Wärmeleitungskörper 3 weist im Bereich unterhalb der Leiterplatte 4 eine größere Dicke auf als an den Bereichen, die nicht vertikal unter der Leiterplatte 4 angeordnet sind. Die Kanäle 2d und 2e weisen einen zum Kanal 2f unterschiedlichen Querschnitt auf. Die weiteren Bezugszeichen entsprechen gleichen oder funktionsgleichen Bauelementen der vorab beschriebenen Ausführungsbeispiele.

Die Draufsicht zu Fig. 5 entspricht derjenigen gemäß Fig. 4. In allen Ausführungsbeispielen kann es auch vorgesehen sein, den Wärmeleitungskörper 3 nur teilweise in die Kunststoff-Schaltplatte 1 zu integrieren und keine Bündigkeit zwischen der Oberfläche O der Kunststoff-Schaltplatte 1 und der Oberfläche des Wärmeleitungskörpers 3 auszubilden.

Der Wärmeleitungskörper 3 kann z.B. durch Einspritzen, Vergießen oder durch Einkleben in eine komplementär geformte Aussparung in die Kunststoff-Schaltplatte 1 eingearbeitet werden.

Die Kanäle in den jeweiligen Ausführungsbeispielen können in vielfältiger Weise gestaltet werden und beispielsweise durch Querkanäle oder dergleichen miteinander verbunden sein.

Sowohl die Leiterplatte 4 als auch die Leiterplatte 5 können durch Auflaminieren bzw. Aufkleben auf die Oberfläche O der Kunststoff-Schaltplatte 1 sowie der Oberfläche des Wärmeleitungskörpers 3 befestigt werden.

Die Gestaltung der Geometrien des Wärmeleitungskörpers 3 und der Kanäle 2a, 2b, 2c, 2d, 2e, 2f und 2' sind durch die in den Figuren dargestellten Möglichkeiten nicht beschränkt. So kann die Geometrie des Wärmeleitungskörpers 3 beispielsweise quader- oder zylinderförmig sein und die Kanäle können beispielsweise einen kreisförmigen oder vieleckigen Querschnitt aufweisen und z.B. eine torusförmige Geometrie zeigen.

## Patentansprüche

1. Anordnung bestehend aus einer Schaltplatte und einer Steuerelektronik mit
- zumindest einem in der Schaltplatte (1) verlaufenden Kanal (2a, 2b, 2c, 2d, 2e, 2f, 2') zur Leitung eines Kühlmediums, und
- einem Wärmeleitungskörper (3), der zumindest teilweise in die Schaltplatte (1) integriert ist und unmittelbar angrenzend an den Kanal (2a, 2b, 2c, 2d, 2e, 2f, 2') angeordnet ist,
wobei die Steuerelektronik, insbesondere ein die Elektronikbauelemente derselben tragendes Substrat (4), unmittelbar auf der Oberfläche des Wärmeleitungskörpers (3) angeordnet ist,
**dadurch gekennzeichnet,**
- **dass** die Steuerelektronik eine Getriebesteuerelektronik ist und
- **dass** die Schaltplatte als Kunststoffkörper ausgebildet ist und einen Teil eines Hydrauliksteuergehäuses eines hydraulischen Kraftfahrzeug-Getriebesteuergerätes bildet.

2. Anordnung nach Anspruch 1,
**dadurch gekennzeichnet,**
**dass** der Wärmeleitungskörper (3) eine Metallplatte, insbesondere eine Aluminiumplatte, ist.

3. Anordnung nach einem der Ansprüche 1 oder 2,
**dadurch gekennzeichnet,**
**dass** der Wärmeleitungskörper (3) so ausgebildet ist, dass er von dem Kühlmedium, insbesondere einer Hydraulikflüssigkeit, angeströmt wird.

4. Anordnung nach einem der vorhergehenden Ansprüche,
**dadurch gekennzeichnet,**
**dass** ein Flächenbereich des Wärmeleitungskörpers (3) als Wandbereich des Kanals (2a, 2b, 2c, 2d, 2e, 2f, 2') ausgebildet ist.

5. Anordnung nach einem der vorhergehenden Ansprüche,
**dadurch gekennzeichnet,**
**dass** der Wärmeleitungskörper (3) U-förmig ausgebildet ist, wobei die Innenseite des U's Wandbereiche des Kanals (2a, 2b, 2c, 2d, 2e, 2f, 2') ausbilden.

6. Anordnung nach einem der vorhergehenden Ansprüche,
**dadurch gekennzeichnet,**
**dass** die Oberfläche (O) der Kunststoff-Schaltplatte (1) bündig mit der Oberfläche des Wärmeleitungskörpers (3) ist.

7. Anordnung nach einem der vorhergehenden Ansprüche,
**dadurch gekennzeichnet,**
**dass** die Getriebesteuerelektronik elektrisch über eine elektrische Leiterplatte (5), insbesondere flexible Leiterplatte, oder über eine Stanzgitteranordnung kontaktiert ist, welche sich teilweise über die Oberfläche (O) der Kunststoff-Schaltplatte (1) und teilweise über die Oberfläche des Wärmeleitungskörpers (3) erstreckt.

## Claims

1. Arrangement comprising a patch board and an electronic control system having
• at least one channel (2a, 2b, 2c, 2d, 2e, 2f, 2') running in the patch board (1) for conducting a cooling agent and
• a heat conduction element (3) which is integrated at least partially into the patch board (1) and is arranged directly adjacent to the channel (2a, 2b, 2c, 2d, 2e, 2f, 2'),
whereby
the electronic control system, in particular a substrate (4) carrying the electronic components of the same, is arranged directly on the surface of the heat conduction element (3) **characterised in that**
• the electronic control system is an electronic control system for a gearbox and
• the patch board is configured as a plastic element and forms part of a hydraulic control housing of a hydraulic motor vehicle gearbox control device.

2. Arrangement according to Claim 1
**characterised in that**
the heat conduction element (3) is a metal plate, in particular an aluminium plate.

3. Arrangement according to one of Claims 1 or 2
**characterised in that**
the heat conduction element (3) is configured such that the cooling agent, in particular a hydraulic fluid, flows against it.

4. Arrangement according to one of the preceding Claims
**characterised in that**
a surface area of the heat conduction element (3) is configured as a wall area of the channel (2a, 2b, 2c, 2d, 2e, 2f, 2')

5. Arrangement according to one of the preceding Claims
**characterised in that**
the heat conduction element (3) is U-shaped, with the inner side of U forming the wall areas of the channel (2a, 2b, 2c, 2d, 2e, 2f, 2')

6. Arrangement according to one of the preceding Claims
**characterised in that**
the surface (0) of the plastic patch board (1) is flush with the surface of the heat conduction element (3).

7. Arrangement according to one of the preceding Claims
**characterised in that**
contact is made with the electronic control system of the gearbox via an electric printed circuit board (5), in particular a flexible printed circuit board, or via a pressed screen arrangement, which extends partially over the surface (0) of the plastic patch board (1) and partially over the surface of the heat conduction element (3) .

## Revendications

1. Dispositif constitué d'une carte de circuits imprimés et d'une électronique de commande, comportant
- au moins un canal (2a, 2b, 2c, 2d, 2e, 2f, 2') s'étendant dans la carte de circuits imprimés (1) pour la circulation d'un milieu de refroidissement, et
- un corps conducteur de la chaleur (3), qui est intégré, au moins en partie, dans la carte de circuits imprimés (1) et qui est disposé directement en limite du canal (2a, 2b, 2c, 2d, 2e, 2f, 2'),
l'électronique de commande, en particulier un substrat (4) portant les constituants électroniques de celle-ci, étant disposée directement sur la surface supérieure du corps conducteur de la chaleur (3),
**caractérisé**
- **en ce que** l'électronique de commande est une électronique de commande de boîte de vitesse, et
- **en ce que** la carte de circuits imprimés est réalisée sous la forme d'un corps en matière plastique et forme une partie d'un boîtier de commande hydraulique d'un appareil hydraulique de commande de boîte de vitesse de véhicule automobile.

2. Dispositif suivant la revendication 1,
**caractérisé en ce que**
le corps conducteur de la chaleur (3) est une plaque métallique, en particulier une plaque d'aluminium.

3. Dispositif suivant l'une des revendications 1 ou 2
**caractérisé en ce que**
le corps conducteur de la chaleur (3) est réalisé de façon à être parcouru par le courant du milieu de refroidissement, en particulier par un courant de liquide hydraulique.

4. Dispositif suivant l'une des revendications précédentes
**caractérisé**
**en ce qu'**une zone de surface du corps conducteur de la chaleur (3) est réalisée sous la forme d'une zone de paroi du canal (2a, 2b, 2c, 2d, 2e, 2f, 2').

5. Dispositif suivant l'une des revendications précédentes
**caractérisé en ce que**
le corps conducteur de la chaleur (3) est réalisé en forme de U, les faces intérieures du U formant des zones de paroi du canal (2a, 2b, 2c, 2d, 2e, 2f, 2').

6. Dispositif suivant l'une des revendications précédentes
**caractérisé en ce que**
la surface supérieure (0) de la carte de circuits imprimés (1) en matière plastique affleure avec la surface supérieure du corps conducteur de la chaleur (3).

7. Dispositif suivant l'une des revendications précédentes
**caractérisé en ce que**
l'électronique de commande de la boîte de vitesse est directement en contact électrique, par l'intermédiaire d'une plaque de circuit imprimé électrique (5), en particulier une plaque de circuit imprimé flexible, ou par un dispositif de grille estampée, qui s'étend en partie au-dessus de la surface supérieure (0) de la carte de circuits imprimés en matière plastique (1) et en partie au-dessus de la surface supérieure du corps conducteur de la chaleur (3).
